# EUROPÄISCHE PATENTSCHRIFT

(11) **EP 2 553 727 B1**
(45) Veröffentlichungstag und Bekanntmachung des Hinweises auf die Patenterteilung: **09.06.2021**
(21) Anmeldenummer: 11730882.5
(22) Anmeldetag: 31.03.2011
(51) Int. Cl.: H01L 33/14, H01L 27/15, H01L 33/00

(54) **OBERFLÄCHENEMITTIERENDE HALBLEITER-LEUCHTDIODE**
SURFACE-EMITTING SEMICONDUCTOR LIGHT-EMITTING DIODE
DIODE SEMI-CONDUCTRICE ELECTROLUMINESCENTE A EMISSION DE SURFACE

(30) Priorität: 01.04.2010 DE 102010014177
(43) Veröffentlichungstag der Anmeldung: 06.02.2013
(73) Patentinhaber: JENOPTIK Optical Systems GmbH, 07745 Jena (DE)
(72) Erfinder: KLOTH, Bernd, 16547 Birkenwerder (DE); ABROSIMOVA, Vera, 12555 Berlin (DE); TRENKLER, Torsten, 12679 Berlin (DE)
(74) Vertreter: Waldauf, Alexander
(86) Internationale Anmeldenummer: PCT/DE2011/050009
(87) Internationale Veröffentlichungsnummer: WO 2011/120513

(56) Entgegenhaltungen:
- DE-A1- 3 709 301
- DE-A1- 19 824 222
- DE-A1- 19 918 651
- DE-T2- 69 125 127
- US-A- 5 663 581
- US-A- 5 799 030
- US-A- 5 882 948
- US-A- 5 893 721
- US-A1- 2003 022 406
- US-A1- 2004 217 361

## Beschreibung

Die Erfindung betrifft eine Halbleiter-Leuchtdiode, wie diese gattungsgemäß aus der US 5,216,263 A bekannt ist.

LED's und LED-Array Chips werden seit einigen Jahrzehnten für die Darstellung von graphischen Zeichen verwendet. Dazu wurden beispielsweise 7-Segment LED-Anzeigechips mittels Zinkdiffusion oder Zinkimplantation in eine dicke n-leitende GaAsP (Galliumarsenidphosphid)-Schicht auf einem GaAs (Galliumarsenid) Substrat entwickelt und bis heute nach der unveränderten Technologie hergestellt. Die typischen Lichtstärken erreichen dabei 0,1 mcd/Segment bei einem Betrieb mit 5 mA Stromstärke. Die Emissionswellenlänge ist durch das Material auf 650-660 nm (rotes Licht) eingeschränkt, bei welcher die Empfindlichkeit des menschlichen Auges nur noch etwa 10% beträgt.

Weitere LED-Displaybauelemente wurden als hybride Elemente entwickelt, bei denen effizientere LED-Chips (etwa 10% Effizienz) mit verschiedenen Emissionswellenlängen im sichtbaren Spektralbereich kombiniert und angeordnet wurden. Die Größe solcher Elemente erlaubt jedoch keine Anwendung in sehr kleinen räumlichen Gegebenheiten, wie z. B. einer Anwendung im Strahlengang optischer Geräte.

Es werden ebenfalls transluzente LCD-Displays mit LED-Hinterleuchtung zur Darstellung graphischer Zeichen verwendet. Diese sind meist relativ große Displays, so dass die LED-Hinterleuchtung ausschließlich mittels Arrays diskreter LED's oder LED-Chips auf einer Trägerplatine erfolgt. Die LED's eines Arrays können sowohl gemeinsam als auch einzeln angesteuert werden. Die LED-Hinterleuchtung kann monochrom, mehrfarbig oder weiß sein.

Um geringe Baugrößen zu ermöglichen, müssen die Halbleiterschichten (Epitaxiestrukturen) kleinräumig strukturiert und ihre optischen und elektrischen Eigenschaften angepasst werden. Neben Diffusion kann mittels sogenannter Implantation von Protonen oder anderer elektrischer Ladungsträger durch eine Bestrahlung die Kristallstruktur verändert oder gar zerstört werden, wodurch die bestrahlten (implantierten) Bereiche ihre elektrische Leitfähigkeit teilweise oder ganz verlieren. Zudem können diese für bestimmte Wellenlängen absorbierend werden. Die Veränderung der Kristalle kann durch die Wahl der den elektrischen Ladungsträgern, verliehenen kinetischen Energien und durch die Anzahl von elektrischen Ladungsträgern je Flächeneinheit (Dosis) eines für die Bestrahlung verwendeten Strahlenbündels gesteuert werden. Um sogenannte tiefenimplantierte Bereiche zu erzeugen, werden die elektrischen Ladungsträger mit einer hohen Energie, aber geringer Dosis, auf das Material gestrahlt, während für die Erzeugung oberflächenimplantierter Bereiche geringe Energien und hohe Dosen eingesetzt werden.

In der US 5,216,263 A ist eine oberflächenemittierende Halbleiter-Leuchtdiode (LED) in einem LED-Array mit einer übereinander angeordnete Folge von Schichten beschrieben, bei der die Folge von Schichten eine Schicht eines Substratkontaktes eines ersten Leitfähigkeitstyps, ein gemeinsames Substrat des ersten Leitfähigkeitstyps, eine erste Barriereschicht des ersten Leitfähigkeitstyps, eine licht-emittierende, aktive Schicht, eine zweite Barriereschicht eines zweiten Leitfähigkeitstyps, eine erste Kontaktschicht des zweiten Leitfähigkeitstyps mit gegeneinander durch Bestrahlung mit Protonen elektrisch isolierten oberflächenimplantierten Bereichen in der ersten Kontaktschicht sowie eine Anzahl von elektrisch leitfähigen Oberflächenkontakten zur Kontaktierung der ersten Kontaktschicht umfasst.

Eine in die Tiefe reichende Strukturierung der Halbleiterschichten wird erzielt, in dem mittels Silizium-Diffusion gestörte Bereiche zwischen einzelnen LED's eines LED-Arrays erzeugt werden, die durch die aktive Schicht hindurch reichen und durch die einzelne emittierende Bereiche der aktiven Schicht gegeneinander elektrisch isoliert sind. Die gestörten Bereiche weisen zudem eine erhöhte Absorption der emittierten Strahlung auf.

Jeder einzelne Bereich der aktiven Schicht ist über einen, diesem Bereich zugeordneten, p-Kontakt auf der ersten Kontaktschicht ansteuerbar. Um emittierte Strahlung auf der dem Substrat zugewandten Seite der Halbleiterschichten abstrahlen zu können, müssen Substratkontakt und Substrat in den Bereichen der emittierenden Oberflächen entfernt werden. Eine Durchstrahlung der angeordneten Schichten ist nicht möglich.

Als Substrat werden durch die US 5,216,263 A ausschließlich n-dotierte Substrate angeführt, während die erste Kontaktschicht p-dotiert ist.

Mit einer Lösung gemäß der US 5,216,263 A sind nachteilig eine Reihe von unterschiedlichen Schritten bei der Strukturierung der Halbleiterschichten nötig. Zum einen sind das eine zeitaufwändige Silizium-Diffusion (7 bis 8 Stunden), gefolgt von einer Bestrahlung mit Protonen und ferner verschiedenen Schritten der Ätzung. Zudem ist aus dem bekannten Stand der Technik keine Lösung bekannt, mittels der das Substrat sowohl n- als auch p-dotiert ausgeführt sein kann.

Eine solche alternative Anwendbarkeit verschiedenartig dotierter Substrate würde jedoch eine Reihe zusätzlicher Möglichkeiten von Schaltungsanordnungen für den Betrieb von LED's und die Herstellung von Chips mit gemeinsamer Anode oder Kathode bieten.

Der Erfindung liegt die Aufgabe zugrunde, eine oberflächenemittierende Halbleiteremittierenden Oberflächen entfernt werden. Eine Durchstrahlung der angeordneten Schichten ist nicht möglich.
Als Substrat werden durch die US 5,216,263 A ausschließlich n-dotierte Substrate angeführt, während die erste Kontaktschicht p-dotiert ist.

Mit einer Lösung gemäß der US 5,216,263 A sind nachteilig eine Reihe von unterschiedlichen Schritten bei der Strukturierung der Halbleiterschichten nötig. Zum einen sind das eine zeitaufwändige Silizium-Diffusion (7 bis 8 Stunden), gefolgt von einer Bestrahlung mit Protonen und ferner verschiedenen Schritten der Ätzung. Zudem ist aus dem bekannten Stand der Technik keine Lösung bekannt, mittels der das Substrat sowohl n- als auch p-dotiert ausgeführt sein kann.

Eine solche alternative Anwendbarkeit verschiedenartig dotierter Substrate würde jedoch eine Reihe zusätzlicher Möglichkeiten von Schaltungsanordnungen für den Betrieb von LED's und die Herstellung von Chips mit gemeinsamer Anode oder Kathode bieten.

Aus US5799030A ist eine Anordnung einer Photodiode mit einer oberflächenemittierenden Laserdiode auf einem gemeinsamen Substrat bekannt, zu deren Herstellung eine Tiefenimplantationstechnik verwendet wird. Eine solche Tiefenimplantationstechnologie kann prinzipiell auch zur Herstellung einer LED eingesetzt werden.

Aus US5663581A ist ein oberflächenemittierendes LED-Array bekannt, zu dessen Herstellung Tiefenimplantationstechniken verwendet werden. Zur Herstellung dieser Vorrichtung ist außerdem ein Ätzprozeß erforderlich, um die oberflächliche Kontaktschicht der LEDs lokal abzuätzen. Nachteilig ist der aufwendige Herstellungsprozeß eines solchen LED Arrays.

Aus US5062115 A ist ein oberflächenemittierendes LED-Array bekannt.

Der Erfindung liegt die Aufgabe zugrunde, eine oberflächenemittierende Halbleiter-Leuchtdiode mit einer gegenüber dem Stand der Technik größeren Lichtstärke vorzuschlagen, die zudem sowohl eine gemeinsame Kathode als auch eine gemeinsame Anode aufweisen können. Weiterhin sollen oberflächenemittierende Halbleiter-Leuchtdioden vorgeschlagen werden, die bei gutem Kontrast zwischen den leuchtenden und den nicht-leuchtenden Bereichen Wellenlängen in einem Spektralbereich von 560 bis 880 nm emittieren und keine Emission aus den Chipkanten aufweisen.

Die Aufgabe wird durch eine oberflächenemittierende Halbleiter-Leuchtdiode (LED) gemäß Anspruch 1 gelöst.

Kern der Erfindung ist eine oberflächenemittierende Halbleiter-LED, die mit wenigen und technologisch gleichartigen Schritten sehr kleinräumig strukturiert ist und hohe Lichtstärken in den Wellenlängenbereichen von blauer bis infraroter Strahlung erlaubt. Die Reflektorschicht dient der Reflektion des von der aktiven Schicht emittierten Lichts in Richtung der emittierenden Oberflächen, wodurch bei einer Emissionswellenlänge von 650 nm erst eine hohe Lichtstärke von z. B. ca. 10 mcd (Millicandela) pro Leuchtsegment an der emittierten Oberfläche erreicht wird. Die Reflektorschicht kann jeden geeigneten Aufbau aufweisen, der eine ausreichende Reflexionsleistung sowie elektrische Leitfähigkeit besitzt. Bevorzugt ist ein verteilter Bragg Reflektor (engl. distributed Bragg reflector) angeordnet.

Die emittierenden Oberflächen weisen eine elektrische Leitfähigkeit eines zweiten Leitfähigkeitstyps auf. An ihnen erfolgt neben der Kontaktierung durch Oberflächenkontakte auch der Austritt des von der aktiven Schicht emittierten Lichtes. Die elektrische Leitfähigkeit der ersten Kontaktschicht zwischen den emittierenden Oberflächen ist durch eine Bestrahlung mit elektrischen Ladungsträgern aufgehoben. Zudem weisen die so bestrahlten Bereiche der ersten Kontaktschicht eine hohe Absorption der von Wellenlängen des von der aktiven Schicht emittierten Lichtes auf, wodurch neben einer elektrischen Isolierung auch eine optische Isolierung der emittierenden Oberflächen vorliegt. Die oberflächenimplantierten Bereiche können auch tiefer als die erste Kontaktschicht ausgebildet sein.

Die emittierende Oberfläche kann beliebig, z. B. rund, balkenförmig, polygonal oder gebogen, geformt sein.

Es kann Strahlung der Wellenlängenbereiche 400 bis 950 nm emittiert werden, wobei die Wellenlängenbereiche 560 bis 880 nm bevorzugt sind.

Es ist ferner wesentlich, dass die tiefenimplantierten Bereiche bis durch die aktive Schicht hindurch ausgeführt sind, um einen gerichteten Stromfluss durch die aktive Schicht zu gewährleisten und um unerwünschte laterale Stromflüsse zu vermeiden. In einer bevorzugten Ausführung der Erfindung reichen die tiefenimplantierten Bereiche durch die erste Kontaktschicht und grenzen unmittelbar an die oberflächenimplantierten Bereiche. Die tiefenimplantierten Bereiche sind vorzugsweise von der ersten Kontaktschicht in senkrechter Richtung erstreckt ausgebildet. Die tiefenimplantierten Bereiche der einzelnen emittierenden Oberflächen können voneinander beabstandet sein, aneinander angrenzen oder ineinander übergehen. Zudem können die tiefenimplantierten Bereiche bis in unterschiedliche Schichten reichen und damit verschiedene Typen von tiefenimplantierten Bereichen bilden. Durch verschiedene Typen tiefenimplantierter Bereiche kann die Folge von Schichten der erfindungsgemäßen LED in beliebig geformte und angeordnete, optisch und elektrisch voneinander isolierte Bereiche strukturiert sein.

Die als oberflächenimplantierte oder tiefenimplantierte Bereiche ausgebildeten optischen und elektrischen Isolierungen sind durch Bestrahlung der Folge von Schichten mit elektrischen Ladungsträgern verschiedener Energien und Dosen erzeugt. Elektrische Ladungsträger für die Bestrahlung können Protonen und Ionen sein.

Der erste Leitfähigkeitstyp und der zweite Leitfähigkeitstyp der erfindungsgemäßen LED ist aus einer die Leitfähigkeitstypen p-dotierter und n-dotierter Halbleiter umfassenden Gruppe ausgewählt, wobei der erste Leitfähigkeitstyp und der zweite Leitfähigkeitstyp voneinander verschieden sind.

Es ist möglich, dass für verschiedene Materialien der Schichten der erfindungsgemäßen LED verschiedene Ionen als Ladungsträger verwendet sind (z. B. für die Konvertierung des Leitfähigkeitstyps vom n-Typ zum p-Typ und vom p-Typ zum n-Typ). Für die Herstellung von hochohmschen Gebieten in GaN-basierten Halbleitern ist es möglich, zur Ladungsträgerimplantation Si-, O-, N-, He- oder Mg-Ionen zu benutzen. Zur Isolation von Zn-dotierter GaAs-Strukturen können z. B. H-, Li-, C- oder O- Ionen implantiert sein.

Weitere Ausführungen der erfindungsgemäßen LED können derart gestaltet sein, dass die oberflächenimplantierten Bereiche und die tiefenimplantierten Bereiche deckungsgleiche horizontale Ausdehnungen aufweisen, sich jedoch vertikal durch die Konzentration und die Art der für die Implantation verwendeten elektrischen Ladungsträger unterscheiden.

Die oberflächenimplantierten Bereiche und die tiefenimplantierten Bereiche können in nur einem Implantationsprozess aufeinander folgend hergestellt sein.

Es ist mit der erfindungsgemäßen LED in äußerst vorteilhafter Weise möglich, dass die den p-n-Übergang enthaltenden Epitaxiestrukturen sowohl auf einem n- als auch auf einem p-dotierten Substrat angeordnet sein können. Dadurch ist die Herstellung von Chips sowohl mit gemeinsamer Anode als auch mit gemeinsamer Kathode möglich. Dabei können die erste Kontaktschicht als auch der Substratkontakt, je nach Ausführung, als Anode oder als Kathode ausgebildet sein.

Die Materialien der ersten und der zweiten Barriereschicht, der ersten Kontaktschicht sowie der aktiven Schicht sind aus einer (Al_{X}Ga_{1-X})_{1-Z}In_{Z}P (Aluminiumgalliumindiumphosphid) und Al_{X}Ga_{1-X}As (Aluminiumgalliumarsenid) umfassenden Gruppe ausgewählt. Besonders bevorzugte Materialien sind durch die Wertebereiche 0 ≤ x ≤ 1 und 0 ≤ z ≤ 0,6 der stöchiometrischen Indizes gegeben. Alternativ kann In_{y}Ga_{1-y}N (Indiumgalliumnitrid) als Material der ersten und der zweiten Barriereschicht, der ersten Kontaktschicht sowie der aktiven Schicht oder einer der Schichten gewählt sein, wobei 0 ≤ y ≤ 0,5 ist. Bei der Verwendung In_{y}Ga_{1-y}N ist das Substrat vorzugsweise aus einer Germanium, Silizium und Metalllegierungen umfassenden Gruppe ausgewählt.

Die Materialien der ersten und der zweiten Barriereschicht, der ersten Kontaktschicht sowie der aktiven Schicht können in einer weiteren Ausführung der erfindungsgemäßen LED aus AlₓGa_{y}In_{z}N bestehen, wobei x+y+z=1, 0 ≤ x ≤ 1, 0 ≤ y ≤ 1, 0 ≤ z ≤ 0,5 sind.

Die Materialien sind dabei so ausgewählt, dass die erste Barriereschicht und die zweite Barriereschicht jeweils eine Bandlücke aufweisen, die größer als die Bandlücke der aktiven Schicht ist.

Die aktive Schicht besteht aus einem undotierten (i-Schicht) oder einem p-dotierten oder einem n-dotierten Material. Die aktive Schicht kann in weiteren Ausführungen in bekannter Weise als sogenanntes quantum well (ein Paar dünner Schichten) oder als multi quantum well (mehrere Paare dünner Schichten) ausgebildet sein. Die aktive Schicht ist nicht tiefer als 4 µm, in bevorzugten Ausführungen jedoch nicht tiefer als 3 µm, unter der emittierenden Oberfläche angeordnet.

Das Substrat kann jedes, für die emittierte Strahlung absorbierende, Halbleitersubstrat sein, wobei GaAs (Galliumarsenid) ein bevorzugtes Substrat ist. Das Substrat kann p- oder n-dotiert sein. Vorzugsweise ist das Substrat aus einem dotierten Material aus einer Gruppe, umfassend Si, GaAs, Ge und Metalllegierungen ausgewählt.

Es ist weiterhin möglich, dass das Substrat ein elektrisch isolierendes Substrat, wie z. B. undotiertes GaAs, hochohmiges Silizium oder nichtleitendes Germanium, ist.

Das elektrisch isolierende Substrat kann ferner aus einem Material ausgewählt aus einer Gruppe, umfassend Saphire, si -AlN, MgAl₂O₄ -Spinel oder Metalloxide, wie beispielsweise MgO oder ZnO, bestehen. Es ist auch möglich, dass das elektrisch isolierende Substrat aus Kompositen, z. B. aus Silikon auf polykristallinem Silikonkarbid (silicon on poly- crystalline silicon carbide; SopSiC), besteht.

Es können verschiedene Materialien und Typen von Substraten, z. B. ein Substrat des ersten oder zweiten Leitfähigkeitstyps und ein elektrisch isolierendes Substrat, miteinander kombiniert, z. B. schichtweise übereinander angeordnet sein.

Das Substrat kann für die emittierte Strahlung absorbierend oder transparent sein.

In weiteren Ausführungen der erfindungsgemäßen LED kann zwischen dem Substrat und der ersten Barriereschicht eine Pufferschicht des ersten Leitfähigkeitstyps zum Ausgleich von voneinander verschiedenen kristallinen Strukturen der Schichten vorhanden sein. Diese Pufferschicht kann beispielsweise eine dotierte Schicht des ersten Leitfähigkeitstyps aus GaAs sein.

Es ist vorteilhaft, wenn sowohl der Substratkontakt als auch die Oberflächenkontakte als Bondflächen ausgeführt sind. Der Substratkontakt als auch die Oberflächenkontakte sind dann, vorzugsweise von einer Bondschicht, ganz oder teilweise überdeckt. Dadurch wird eine einfachere, sichere und haltbare Kontaktierung der ersten Kontaktschicht bzw. des Substrates erreicht.

In weiteren Ausführungen der erfindungsgemäßen LED, bei denen ein elektrisch isolierendes Substrat vorhanden ist, kann der Substratkontakt mit der Pufferschicht durch mindestens einen metallischen Leiter verbunden sein. Der metallische Leiter ist vorzugsweise so angeordnet, dass er durch Kanäle in dem elektrisch isolierenden Substrat verläuft.

Es ist auch möglich, dass die elektrisch zu kontaktierenden Schichten der erfindungsgemäßen LED, insbesondere die der Pufferschicht, dadurch kontaktierbar sind, dass mit elektrisch leitendem Material gefüllte Mikrolöcher in dem isolierenden Substrat vorhanden sind. Mikrolöcher sind Perforierungen mit einem freien Durchmesser von maximal 10 µm.

Es ist dabei vorteilhaft, wenn der Substratkontakt einen omni-direktionalen Reflektor darstellt. Ein omni-direktionaler Reflektor ist dann gebildet, wenn sich die Schichten der erfindungsgemäßen LED auf einem für die emittierte Strahlung transparenten Substrats befindet und die Unterseite des Substrats mit einer die emittierte Strahlung reflektierende Schicht (z. B. aus Al, Ag, Cr oder Au) versehen ist.

Sind Kanäle in dem elektrisch isolierenden Substrat vorhanden, können diese ebenfalls auf ihren Innenflächen beschichtet sein. Es ist ferner möglich, dass der metallische Leiter selbst eine reflektierende Schicht darstellt.

Es ist ferner möglich, dass zwischen der zweiten Barriereschicht und der ersten Kontaktschicht eine Stromverteilerschicht des zweiten Leitfähigkeitstyps zur Verteilung eines zwischen der ersten Kontaktschicht und dem Substratkontakt fließenden Stromes über einen leitenden Querschnitt vorhanden ist.

Eine Stromverteilerschicht dient der äußerst vorteilhaften Erzeugung eines Stromflusses über einen gesamten elektrisch leitenden Querschnitt. Dieser elektrisch leitende Querschnitt entspricht dem horizontalem Querschnitt, der jeweils unter einer emittierenden Oberfläche angeordneten Bereichen der Schichten, und wird lateral, durch die tiefenimplantierten Bereiche der Folge von Schichten, optisch und elektrisch isoliert. Die vorteilhafte Wirkung einer solchen Schicht besteht darin, dass die aktive Schicht über ihren gesamten Querschnitt von Strom durchflossen wird und damit eine gleichmäßige und hohe Lichtausbeute ermöglicht wird. Das Material der Stromverteilerschicht kann beispielsweise p- oder n-dotiertes AlInGaP oder AlGaAs oder InGaN sein, wobei sie für das von der aktiven Schicht emittierte Licht durchlässig ist.

Die Stromverteilerschicht kann aus einem, für die emittierte Strahlung transparenten, leitfähigen Material, wie z. B. Indiumzinnoxid (ITO) oder Zinkoxid (ZnO), bestehen. Dem Material der Stromverteilerschicht beigemischte Stoffe zur Dotierung sind so gewählt, dass die Stromverteilerschicht vom ersten oder zweiten Leitungsfähigkeitstyp ist und dem Typ der Leitungsfähigkeit der zweiten Barriereschicht entspricht.

Die erfindungsgemäße LED kann in einem LED-Array angeordnet sein, bei dem eine Anzahl von emittierenden Oberflächen auf einem gemeinsamen Substrat in einem Muster angeordnet sind, wobei aus Zeilen und Spalten aufgebaute Muster bevorzugt sind.

Ein solches LED-Array kann so gestaltet sein, dass die LED's des Arrays einzeln und voneinander unabhängig ansteuerbar sind. In einer vorteilhaften Ausführung reichen die tiefenimplantierten Bereiche durch alle Schichten bis zu einem elektrisch isolierenden Substrat. Zwischen einer Pufferschicht und der Reflektorschicht ist dann eine zweite Kontaktschicht eines ersten Leitfähigkeitstyps vorhanden. Es ist auch möglich, dass die zweite Kontaktschicht zugleich als Pufferschicht ausgebildet ist. Die zweite Kontaktschicht kann, je nach Wahl der Leitfähigkeitstypen, Anode oder Kathode sein.

Es ist vorteilhaft, wenn Mittel zur selektiven Ansteuerung einer LED vorhanden sind, so dass es zu keinen Emissionen von Licht durch benachbart angeordnete, nicht angesteuerte LED's kommt. Solche Mittel können jedwede Anordnungen von Kontakten und einer Steuerung eines LED-Arrays mit erfindungsgemäßen LED's sein, mit denen eine selektive Ansteuerung einer LED erreichbar ist. Eine einfache und bevorzugte Ausführung stellen sich kreuzende, streifenförmige und in verschiedenen Schichten ober- bzw. unterhalb der aktiven Schicht verlaufende Kontakte dar (multiplexe Ansteuerung). Es ist ferner möglich, Gruppen von LED's gemeinsam anzusteuern.

Wird eine erfindungsgemäße LED angesteuert, so kommt es bei Anliegen einer ausreichend großen Spannung, zu einem Stromfluss von der Anode zur Kathode. Wie oben beschrieben, kann der Stromfluss, in Abhängigkeit von den Dotierungen der ober- und unterhalb der aktiven Schicht angeordneten Schichten, von der ersten Kontaktschicht zu dem Substratkontakt bzw. der zweiten Kontaktschicht fließen oder aber er fließt von dem Substratkontakt bzw. der zweiten Kontaktschicht hin zur ersten Kontaktschicht. Die laterale Ausbreitung des Stromflusses ist durch die tiefenimplantierten Bereiche begrenzt, weshalb der Stromfluss über den leitenden Querschnitt, der unter der emittierenden Oberfläche befindlichen Schichten im Wesentlichen vertikal und gerichtet erfolgt. In der aktiven Schicht erfolgt in bekannter Weise die Emission von Strahlung. In Richtung des Substrates emittierte Strahlung trifft auf die Reflektorschicht und wird durch diese in Richtung der emittierenden Oberfläche reflektiert. Einer lateralen Ausbreitung emittierter Strahlung wird durch die optisch isolierenden, tiefenimplantierten Bereiche begegnet.

Die Erfindung wird nachfolgend anhand von Ausführungsbeispielen und Abbildungen näher beschrieben. Dabei zeigen:

Fig. 1 eine erste Ausführung der erfindungsgemäßen LED mit einem n-dotierten Substrat,
Fig. 2 eine zweite Ausführung der erfindungsgemäßen LED mit einem p-dotierten Substrat,
Fig. 3 eine dritte Ausführung der erfindungsgemäßen LED mit einem n-dotierten Substrat,
Fig. 4 eine vierte Ausführung der erfindungsgemäßen LED mit einem undotierten Substrat,
Fig. 5 eine erste Anordnung von erfindungsgemäßen LED's in der Draufsicht,
Fig. 6 eine zweite Anordnung von erfindungsgemäßen LED's in einem Zifferndisplay in der Draufsicht,
Fig. 7 eine dritte Anordnung von erfindungsgemäßen LED's in der Draufsicht,
Fig. 8 ein LED-Array mit erfindungsgemäßen LED's in der Draufsicht,
Fig. 9 ein Beispiel eines LEDs , das zum Verständnis der Erfindung beiträgt, mit oberflächenimplantierten und tiefenimplantierten Bereichen gleicher horizontaler Ausdehnung,
Fig. 10 ein zweites Beispiel eines LEDs, das zum Verständnis der Erfindung beiträgt, mit oberflächenimplantierten und tiefenimplantierten Bereichen gleicher horizontaler Ausdehnung, isolierendem Substrat und omni-direktionalen Reflektor und
Fig. 11 eine erfindungsgemäße LED als Punktstrahler in der Draufsicht.

Die Folgen von Schichten der nachfolgenden Ausführungsbeispiele sind mittels bekannter Verfahren zur Erzeugung von schichtweisen Epitaxiestrukturen hergestellt. Ebenso sind die oberflächen- und tiefenimplantierten Bereiche mittels bekannter Verfahren erzeugt.

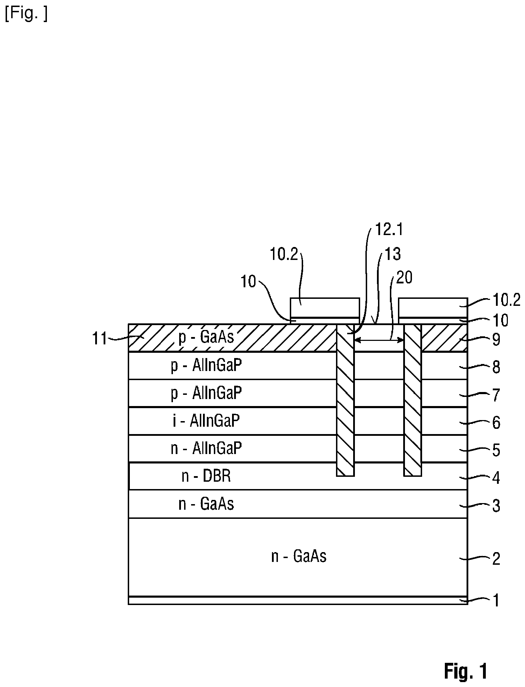

In einer ersten Ausführung einer LED gemäß Fig. 1 ist eine Folge von Schichten angeordnet, die der Emission von gelbem Licht in einem Wellenlängenbereich von 575 bis 595 nm dient.

Als unterste Schicht ist ein Substratkontakt 1, der als ohmscher n-Kontakt (Kathode) ausgeführt ist und aus Gold besteht sowie ein n-dotiertes, aus einem GaAs-Einkristall (Galliumarsenid) bestehendes Substrat 2 vorhanden, das mit dem Substratkontakt 1 flächig und elektrisch leitend verbunden ist. Über dem Substrat 2 ist eine Pufferschicht 3 aus n-GaAs angeordnet, gefolgt von einer Reflektorschicht 4, die als verteilter Bragg Reflektor (DBR) ausgebildet und so strukturiert ist, dass von oberhalb auf die Reflektorschicht 4 auftreffendes gelbes Licht wieder nach oberhalb der Reflektorschicht 4 reflektiert wird. Über der Reflektorschicht 4 befindet sich eine erste Barriereschicht 5 aus n-AlInGaP, gefolgt von einer aktiven Schicht 6 aus i-AlInGaP und einer zweiten Barriereschicht 7 aus p-AlInGaP. Die Bandlücke der ersten und der zweiten Barriereschicht sind größer als die Bandlücke der aktiven Schicht 6. Die aktive Schicht 6 ist als ein multi quantum well gestaltet. Die aktive Schicht 6 kann in weiteren Ausführungen als p- oder n-dotierte Schicht, als undotierte Schicht oder als quantum well ausgebildet sein.

In weiteren Ausführungen kann der Substratkontakt 1 auch aus Germanium oder Gold/Germanium bestehen.

Über der zweiten Barriereschicht 7 sind eine Stromverteilerschicht 8 aus p-AlInGaP und eine erste Kontaktschicht 9 aus p-GaAs (Anode) vorhanden.

Ausgehend von der ersten Kontaktschicht 9 ist ein, durch Bestrahlung mit Protonen, erster tiefenimplantierter Bereich 12.1 bis in die Reflektorschicht hinein reichend vorhanden. Der erste tiefenimplantierte Bereich 12.1 weist einen ringförmigen, über die senkrechte Ausdehnung des ersten tiefenimplantierten Bereichs 12.1 gleichbleibenden, Querschnitt auf. Die nicht dem ersten tiefenimplantierten Bereich 12.1 angehörende Fläche des Querschnittes stellt dabei einen elektrisch leitenden Querschnitt 20 (Durchmesser gezeigt) dar. Die dem leitenden Querschnitt 20 zugeordneten Bereiche, der von dem ersten tiefenimplantierten Bereich 12.1 durchdrungenen Schichten, sind in lateraler Richtung optisch und elektrisch isoliert.

Die erste Kontaktschicht 9 weist um den ersten tiefenimplantierten Bereich 12.1 einen durch Bestrahlung mit Protonen oberflächenimplantierten Bereich 11 auf (schraffiert). Auf der Oberfläche der ersten Kontaktschicht 9 sind Oberflächenkontakte 10 vorhanden, durch die der leitende Querschnitt 20 gleichmäßig und über den ganzen Umfang des leitenden Querschnitts 20 auf der Oberfläche der ersten Kontaktschicht 9 kontaktiert ist. Die Oberflächenkontakte 10 sind von einer Bondfläche 10.2 vollständig überdeckt. Die verbleibende freie Fläche des leitenden Querschnitts 20 an der Oberfläche der ersten Kontaktschicht 9 stellt eine emittierende Oberfläche 13 dar, über die das in der aktiven Schicht 6 emittierte und die emittierende Oberfläche 13 erreichende und durchdringende Licht ausgesendet wird. Die aktive Schicht 6 ist 3 µm unter der emittierenden Oberfläche 13 angeordnet. Die erreichbare Lichtstärke beträgt 15 mcd pro LED bei einem Betrieb bei 5 mA.

In weiteren Ausführungen kann das Material der ersten und der zweiten Barriereschicht 5, 7, der ersten Kontaktschicht 9 sowie der aktiven Schicht 6 auf einem absorbierenden Substrat 2 zur Emission blauer und grüner Strahlung sein.

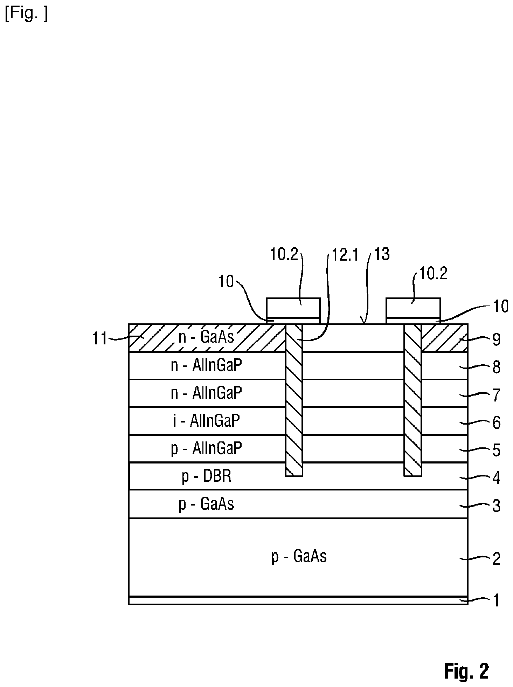

Eine zweite Ausführung der LED weist gemäß Fig. 2 die gleichen Schichten in der gleichen Anordnung wie die erste Ausführung auf und dient der Emission von rotem Licht in einem Wellenlängenbereich von 640 bis 660 nm. Die Dotierungen der Materialien sind von denen der ersten Ausführung dahingehend verschieden, dass die einzelnen Schichten aus anders dotierten Materialien bestehen. So sind das Substrat 2, die Pufferschicht 3, die Reflektorschicht 4 und die erste Barriereschicht 5 p-dotiert, während die zweite Barriereschicht 7, die Stromverteilerschicht 8 und die erste Kontaktschicht 9 n-dotiert sind. Die aktive Schicht 6 ist 3 µm unter der emittierenden Oberfläche 13 angeordnet.

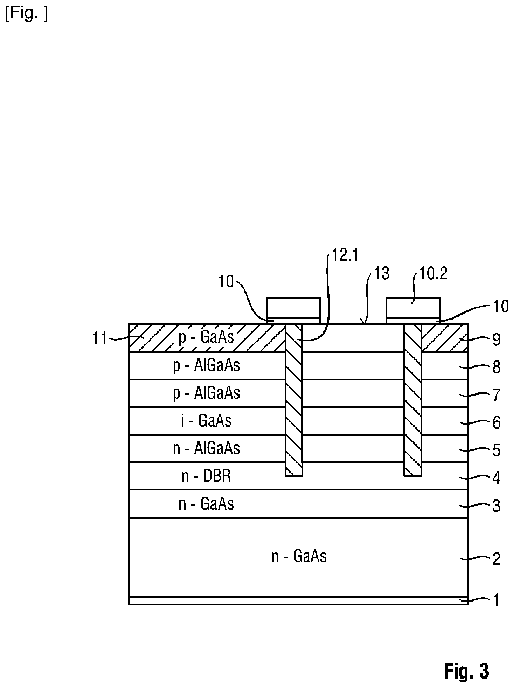

In einer dritten Ausführung der LED sind gemäß Fig. 3 wiederum alle Schichten in der gleichen Anordnung wie in der ersten und in der zweiten Ausführung vorhanden. Mittels dieser Ausführung wird infrarote Strahlung der Wellenlänge 860 nm abgestrahlt. Das Substrat 2, die Pufferschicht 3, die Reflektorschicht 4 und die erste Barriereschicht 5 sind n-dotiert, während die zweite Barriereschicht 7, die Stromverteilerschicht 8 und die erste Kontaktschicht 9 p-dotiert sind. Im Unterschied zu der ersten und der zweiten Ausführung der LED bestehen die erste und die zweite Barriereschicht 5, 7 sowie die Stromverteilerschicht 8 aus dotiertem AlGaAs. Die aktive Schicht 6 ist ein multi quantum well aus AlGaAs und ist 3 µm unter der emittierenden Oberfläche 13 angeordnet.

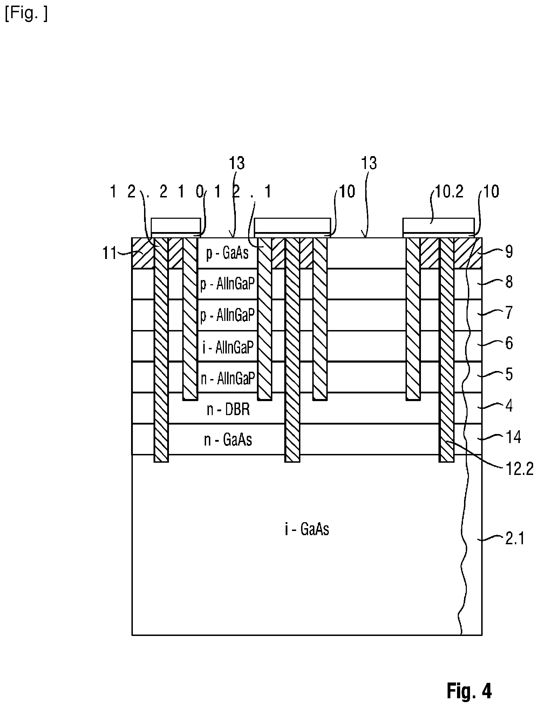

In Fig. 4 sind zwei erfindungsgemäße LED's einer vierten Ausführung auf einem gemeinsamen Substrat 2 gezeigt, wobei das Substrat 2 ein elektrisch isolierendes Substrat 2.1 aus undotiertem GaAs ist. Über dem isolierenden Substrat 2.1 ist eine zweite Kontaktschicht 14 aus n-dotiertem GaAs vorhanden. Darüber folgen eine n-dotierte, als DBR ausgebildete, Reflektorschicht 4, eine erste Barriereschicht 5 aus n-AlInGaP, ein multi quantum well aus i-AlInGaP als aktive Schicht 6, eine zweite Barriereschicht 7 aus p-AlInGaP, eine Stromverteilerschicht 8 aus p-AlInGaP und eine erste Kontaktschicht 9 aus p-GaAs. Die ersten tiefenimplantierten Bereiche 12.1 reichen von der ersten Kontaktschicht 9 bis in die Reflektorschicht 4 hinein. Die Oberflächenkontakte 10 und die Bondflächen 10.2 sind wie in den oben beschriebenen ersten bis dritten Ausführungen gestaltet. Zusätzlich sind parallel zueinander verlaufende zweite tiefenimplantierte Bereiche 12.2 vorhanden, die von der ersten Kontaktschicht 9 bis in das isolierende Substrat 2.1 hinein ausgebildet sind. Ein zweiter tiefenimplantierter Bereich 12.2 ist zwischen den beiden LED's und ununterbrochen von einer Seite der Folge von Schichten der LED zur anderen Seite der Folge von Schichten verlaufend ausgebildet, wodurch diese die beiden LED's über alle Schichten optisch und elektrisch voneinander isolieren. Die LED's sind durch weitere zweite tiefenimplantierte Bereiche 12.2 gegen die Seiten der Folge von Schichten isoliert.

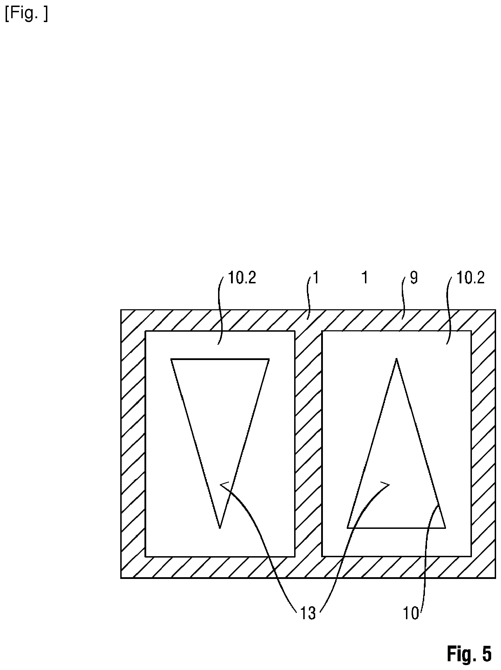

Ausgestaltungen und Anordnungen der erfindungsgemäßen LED's sind in den Fign. 5 bis 8 dargestellt. In der Fig. 5 ist eine Anordnung zweier LED's mit dreieckigen emittierenden Oberflächen 13 gezeigt. Die erste Kontaktschicht 9 weist oberflächenimplantierte Bereiche 11 auf, durch welche die beiden emittierenden Oberflächen 13 optisch und elektrisch gegeneinander isoliert sind. Über den Oberflächenkontakten 10 (nicht gezeigt) sind Bondflächen 10.2 vorhanden.

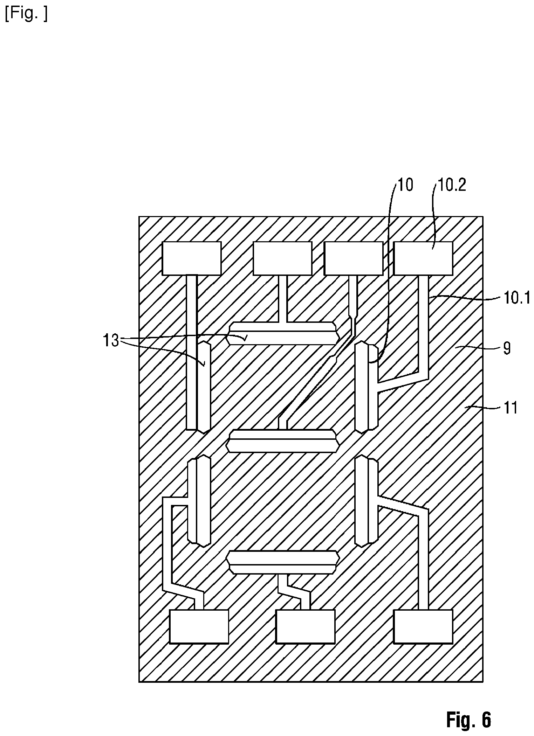

Die Lage der emittierenden Oberflächen 13 in der ersten Kontaktschicht 9 können gemäß der Fig. 6 auch für die Darstellung von Ziffern vorgesehen sein. Die emittierenden Oberflächen 13 der insgesamt sieben LED's sind einzeln über als Streifen 10.1 ausgebildete Oberflächenkontakte 10 kontaktiert und mit je einer Bondfläche 10.2 elektrisch leitend verbunden. Oberflächenkontakte 10 und emittierende Oberflächen 13 sind durch oberflächenimplantierte Bereiche 11 voneinander optisch und elektrisch isoliert und dadurch einzeln und unabhängig voneinander ansteuerbar.

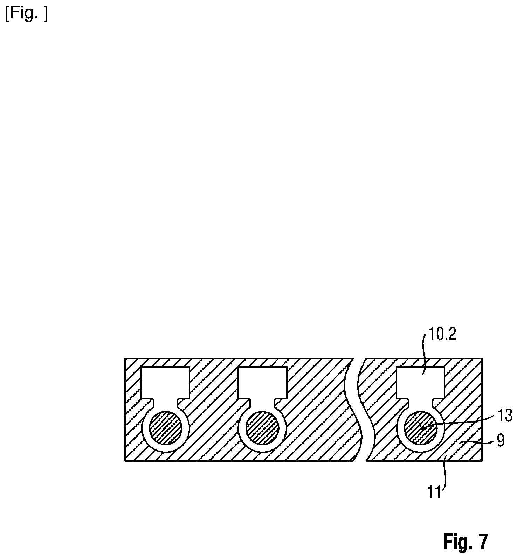

Eine ähnliche Anordnung ist in Fig. 7 gezeigt. In sichtbarem Licht leuchtende oder infrarot strahlende, runde emittierende Oberflächen 13 mit einem Durchmesser von je 50 µm sind durch separate, jeweils gebondete Oberflächenkontakte 10 kontaktiert und einzeln ansteuerbar.

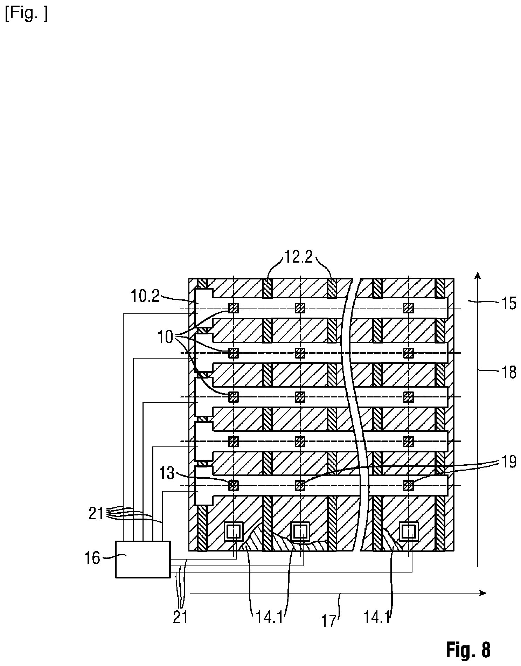

In der Fig. 8 sind eine Anzahl von emittierenden Oberflächen 13 auf einem gemeinsamen isolierenden Substrat 2.1 in einem Array 15 (LED-Array) angeordnet, wobei die Folge der Schichten der vierten Ausführung der LED's gemäß Fig. 4 entspricht.

Die Oberflächenkontakte 10 sind als Streifen 10.1 ausgebildet, die durch die oberflächenimplantierten Bereiche 11 der ersten Kontaktschicht 9 gegeneinander elektrisch isoliert sind. Durch die Streifen 10.1 sind je eine Anzahl von emittierenden Oberflächen 13 in einer ersten Richtung 17 des Arrays 15 kontaktiert. Die zweite Kontaktschicht 14 ist als eine Anzahl voneinander elektrisch isolierter Streifen 14.1 ausgebildet, die in einer senkrecht zur ersten Richtung 17 des Arrays 15 weisenden zweiten Richtung 18 des Arrays 15 verlaufen, so dass durch die in der ersten Richtung 17 verlaufenden Streifen 10.1 und die in der zweiten Richtung 18 verlaufendenden Streifen 14.1 in der Draufsicht ein Netz (gestrichelt angedeutet) mit Kreuzungspunkten 19 der Streifen 10.1 und 14.1 gebildet ist und jede emittierende Oberfläche 13 über je einem der Kreuzungspunkte 19 angeordnet ist. Die Streifen 10.1 sind, über an einer ihrer Enden befindlichen Bondflächen 10.2, kontaktierbar. Die Streifen 14.1 sind an einem ihrer Enden von der ersten Kontaktschicht 9 her punktuell mittels chemischer oder Plasmaätzung freigelegt. Die freigelegten Bereiche der Streifen 14.1 sind einzeln kontaktierbar.

Ferner ist eine Steuerung 16 vorhanden, die mit den Streifen 10.1 und den Streifen 14.1 jeweils über Leitungen 21 selektiv kontaktierbar ausgeführt ist, so dass durch die Steuerung 16 für jede emittierende Oberfläche 13 einzeln und unabhängig von anderen emittierende Oberflächen 13, ein gerichteter Stromfluss zwischen einem Streifen 10.1 und einem Streifen 14.1 senkrecht zu einem Kreuzungspunkt 19 steuerbar ausgelöst werden kann.

In weiteren Ausführungen können die Streifen 14.1 aus der Folge von Schichten herausragende Bondflächen 10.2 aufweisen oder mittels anderer bekannter Verfahren punktuell oder flächig freigelegt sein.

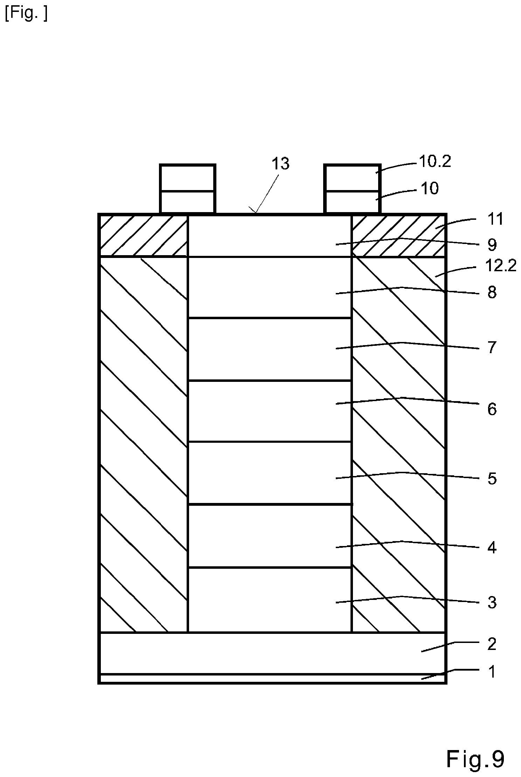

Ein erstes Beispiel einer LED, das zum Verständnis der Erfindung beiträgt, ist in Fig. 9 gezeigt. Die oberflächenimplantierten Bereiche 11 und die tiefenimplantierten Bereiche 12 weisen die gleichen horizontalen Ausdehnungen auf und sind deckungsgleich untereinander angeordnet. Es sind zwei vertikal verlaufende und in horizontaler Richtung voneinander getrennt angeordnete Bereiche (schraffierte Bereiche links und rechts) mit deckungsgleich übereinander angeordneten oberflächenimplantierten Bereichen 11 und tiefenimplantierten Bereichen 12 gebildet. Die tiefenimplantierten Bereiche 12 sind als zweite tiefenimplantierten Bereiche 12.2 ausgebildet und reichen von den oberflächenimplantierten Bereichen 11 bis zum Substrat 2. Das Substrat 2 ist vom ersten oder zweiten Leitfähigkeitstyp.

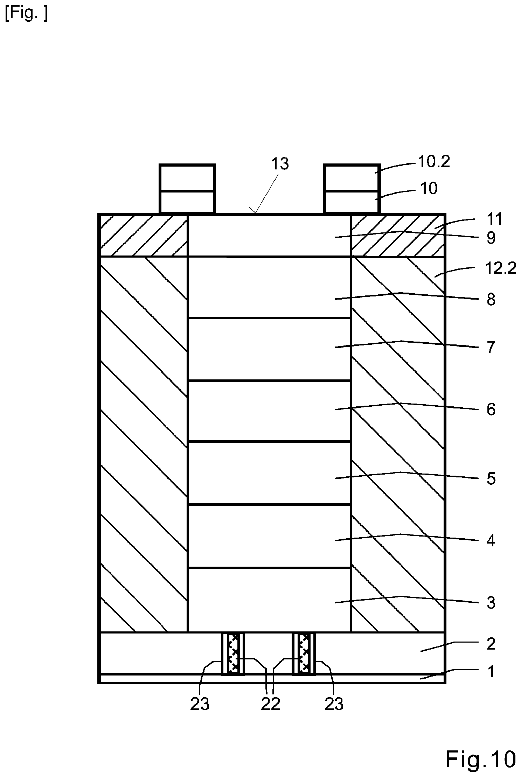

Die Fig. 10 zeigt ein zweites Beispiel einer LED, das zum Verständnis der Erfindung beiträgt, das dem grundsätzlichen Aufbau gemäß Fig. 9 entspricht. In der sechsten Ausführung ist ein elektrisch isolierendes Substrat 2.1 vorhanden, in dem zwei vertikal verlaufende Kanäle 23 in dem elektrisch isolierenden Substrat 2.1 enthalten sind, in denen je ein metallischer Leiter 22 so angeordnet ist, dass der Substratkontakt 1 und die Pufferschicht 3 durch die metallischen Leiter 22 kontaktiert und elektrisch leitend miteinander verbunden sind. Die Pufferschicht 3 ist durch die metallischen Leiter 22 unterhalb der emittierenden Oberfläche 13 kontaktiert. Das elektrisch isolierende Substrat 2.1 ist für die emittierte Strahlung transparent und weist auf seiner Unterseite eine Gold-Beschichtung auf. Durch das so beschichtete elektrisch isolierende Substrat 2.1 ist in Zusammenwirken mit den über dem elektrisch isolierenden Substrat 2.1 angeordneten Schichten der erfindungsgemäßen LED ein omni-bidirektionaler Reflektor gebildet.

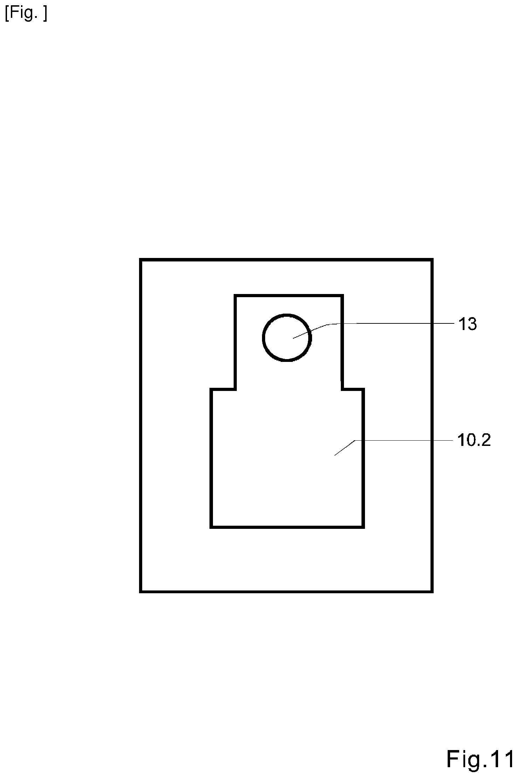

In einer Anwendung der erfindungsgemäßen LED gemäß Fig. 11 ist ein so genannter Punktstrahler Chip in der Draufsicht gezeigt. Die emittierende Oberfläche 13 ist kreisrund ausgebildet, ist von der Bondfläche 10.2 umfangen und hat einen Durchmesser von 50 µm. In weiteren Ausführungen kann der Durchmesser kleiner, z. B. 25 µm, oder größer, z. B. 150 µm, sein. Es wird Strahlung mit einer Wellenlänge von 650 nm (rot) emittiert, wobei sichtbare Emissionen bereits ab 400 nA erhalten werden. Die Lichtstärke liegt im Vergleich zu Punktstrahler Chips der 1. Generation um etwa den Faktor 5 höher. Der Punktstrahler Chip erlaubt eine hohe Strombelastung von 200 A/cm2 und geringe Schaltzeiten (< 5 ns). Da die Punktstrahler Chips eine Lebensdauer von > 100.000 h (bei 100 A/cm2) aufweisen, sind diese für eine Verwendung in der Datenübertragung besonders geeignet. Eine hohe Effizienz der erfindungsgemäßen LED in dem Punktstrahler Chip erlaubt eine lange Lebensdauer von Batterien bei nicht-stationärer Verwendung der Punktstrahler Chips oder von Geräten und Anlagen, in denen die Punktstrahler Chips enthalten sind.

So sind diese Punktstrahler Chips z. B. für VCSEL-Substitutionen ohne Specklebildung, als Strahlquelle für Drehgeber-Sensoren (Encoder), als Miniatur Lichtpunkte für Zieloptiken, als fokussierter Strahl für Lichtschranken und Punktzeilen-Arrays für Laserdrucker verwendbar.

Die erfindungsgemäßen LED's können in einer Vielzahl von Bereichen angewendet werden. So eignen sie sich außerdem zur Hinterleuchtung von Anzeigen zur Darstellung optisch wahrnehmbarer graphischer Zeichen oder zur Einspiegelung von optisch wahrnehmbaren graphischen Zeichen in den Strahlengang einer optischen Anordnung. Durch die hohe Lichtstärke der LED's können durch Absorption, Teilreflexion, Streuung und/oder Interferenzen auftretende Verluste leicht ausgeglichen werden. Zudem sind die erfindungsgemäßen LED's aufgrund ihrer guten Kontrasteigenschaften auch für die Darstellung kleiner und/oder hochauflösender graphischer Zeichen einsetzbar.

### Bezugszeichenliste

1 Substratkontakt
2 Substrat
2.1 elektrisch isolierendes Substrat
3 Pufferschicht
4 Reflektorschicht
5 erste Barriereschicht
6 aktive Schicht
7 zweite Barriereschicht
8 Stromverteilerschicht
9 erste Kontaktschicht
10 Oberflächenkontakte
10.1 Streifen
10.2 Bondfläche
11 oberflächenimplantierter Bereich
12 tiefenimplantierten Bereichen
12.1 erster tiefenimplantierter Bereich
12.2 zweiter tiefenimplantierter Bereich
13 emittierende Oberfläche
14 zweite Kontaktschicht
14.1 Streifen
15 Array
16 Steuerung
17 erste Richtung
18 zweite Richtung
19 Kreuzungspunkt
20 leitender Querschnitt
21 Leitung
22 metallischer Leiter
23 Kanal

## Patentansprüche

1. Eine oberflächenemittierende Halbleiter-Leuchtdiode, LED, beinhaltend eine übereinander angeordnete Folge von:
- einer Schicht eines Substratkontaktes (1) eines ersten Leitfähigkeitstyps,
- einem gemeinsamen Substrat (2),
- einer ersten Barriereschicht (5) des ersten Leitfähigkeitstyps,
- einer licht-emittierenden, aktiven Schicht (6),
- einer zweiten Barriereschicht (7) eines zweiten Leitfähigkeitstyps, einer ersten Kontaktschicht (9) des zweiten Leitfähigkeitstyps und gegeneinander durch Bestrahlung mit elektrischen Ladungsträgern elektrisch isolierten oberflächenimplantierten Bereichen (11) in der ersten Kontaktschicht (9) sowie einer Anzahl von elektrisch leitfähigen Oberflächenkontakten (10) zur Kontaktierung der ersten Kontaktschicht (9), **dadurch gekennzeichnet,**
- **dass** das Substrat (2) aus einem Halbleitersubstrat besteht und das Substrat (2) einen ersten Leitfähigkeitstyp aufweist oder das Substrat (2) ein elektrisch isolierendes Substrat (2.1) ist oder das Substrat (2) aus einem Metall oder aus einem Kompositmaterial besteht,
- **dass** zwischen dem Substrat (2) und der ersten Barriereschicht (5) eine Reflektorschicht (4) des ersten Leitfähigkeitstyps vorhanden ist,
- **dass** die erste Kontaktschicht (9) mindestens eine emittierende Oberfläche (13) aufweist, über die von der aktiven Schicht (6) emittierte Strahlung aus der LED austritt und die emittierenden Oberflächen (13) durch mit elektrischen Ladungsträgern bestrahlten, oberflächenimplantierten Bereichen (11) in der ersten Kontaktschicht (9) umgeben sind, welche elektrisch und optisch isolierendt ausgebildet sind und
- **dass** die unter der emittierenden Oberfläche (13) befindlichen Bereiche der Schichten, ausgehend von der ersten Kontaktschicht (9) bis mindestens durch die aktive Schicht (6) hindurch und bis in die Reflektorschicht (4) hineinreichend, durch mit elektrischen elektrisch und optisch gegen nicht unter der emittierenden Oberfläche (13) befindliche Bereiche der Schichten isoliert sind, wobei die tiefenimplantierten Bereiche (12.1) von der ersten Kontaktschicht (9) in senkrechter Richtung erstreckt ausgebildet sind und
- **dass** die tiefenimplantierten Bereiche (12.1) eine kleinere horizontale Ausdehnung aufweisen, als die oberflächenimplantierten Bereiche (11) und dass die tiefenimplantierten Bereiche einen ringförmigen, über die senkrechte Ausdehnung der tiefenimplantierten Bereiche gleichbleibenden Querschnitt, aufweisen und dass die oberflächenimplantierten Bereiche vollflächig über die gesamte Oberfläche der LED mit Ausnahme der emittierenden Oberflächen (13) ausgedehnt sind.

2. LED nach Anspruch 1, **dadurch gekennzeichnet, dass** mehrere emittierende Oberflächen (13) vorhanden sind und die tiefenimplantierten Bereiche (12.1, 12.2) der einzelnen emittierenden Oberflächen (13) voneinander beabstandet sind.

3. LED nach Anspruch 1, **dadurch gekennzeichnet, dass**
der erste Leitfähigkeitstyp und der zweite Leitfähigkeitstyp aus einer der Leitfähigkeitstypen p-dotierter und n-dotierter Halbleiter umfassenden Gruppe ausgewählt ist und der erste Leitfähigkeitstyp und der zweite Leitfähigkeitstyp voneinander verschieden sind.

4. LED nach Anspruch 2, **dadurch gekennzeichnet, dass**
die erste Barriereschicht (5) und die zweite Barriereschicht (7) jeweils eine Bandlücke aufweisen, die größer als die Bandlücke der aktiven Schicht (6) ist.

5. LED nach Anspruch 3, **dadurch gekennzeichnet, dass**
die Materialien der ersten und der zweiten Barriereschicht (5, 7), der ersten Kontaktschicht (9) sowie der aktiven Schicht (6) aus einer (AlₓGa₁₋ₓ)_{1-z}In_{z}P und AlₓGa₁₋ₓAs umfassenden Gruppe ausgewählt sind, wobei 0 ≤ x ≤ 1 und 0 ≤ z ≤ 0,6 sind oder die Materialien der ersten und der zweiten Barriereschicht (5, 7), der ersten Kontaktschicht (9) sowie der aktiven Schicht (6) aus AlₓGa_{y}In_{z}N besteht, wobei x+y+z=1, 0 ≤ x ≤ 1, 0 ≤ y ≤ 1, 0 ≤ z ≤ 0,5 sind oder als Material der ersten und der zweiten Barriereschicht (5, 7), der ersten Kontaktschicht (9) sowie der aktiven Schicht (6) In_{y}Ga_{1-y}N ausgewählt ist, wobei 0 ≤ y ≤ 0,5 ist und das Substrat (2) aus einer Germanium, Silizium und Metalllegierungen umfassenden Gruppe ausgewählt ist.

6. LED nach Anspruch 1, **dadurch gekennzeichnet, dass**
die aktive Schicht (6) als quantum well oder multi quantum well ausgebildet ist oder aus einem undotierten oder einem p-dotierten oder einem n-dotierten Material besteht und nicht tiefer als 4 µm unter der emittierenden Oberflächen (13) angeordnet ist.

7. LED nach Anspruch 1, **dadurch gekennzeichnet, dass**
das Substrat (2) aus einem dotierten Material, ausgewählt aus einer Gruppe umfassend Si, GaAs, Ge und Metalllegierungen, besteht.

8. LED nach Anspruch 1, **dadurch gekennzeichnet, dass**
das Substrat (2) als ein elektrisch isolierendes Substrat (2.1) ausgebildet ist und das elektrisch isolierende Substrat (2.1) aus einem Material, ausgewählt aus einer Gruppe umfassend Saphire, si -AlN, MgAl₂O₄ -Spinel, Metalloxide oder Kompositen besteht..

9. LED nach Anspruch 1, **dadurch gekennzeichnet, dass**
zwischen Substrat (2) und erster Barriereschicht (5) eine Pufferschicht (3) des ersten Leitfähigkeitstyps zum Ausgleich von voneinander verschiedenen kristallinen Strukturen der Schichten vorhanden ist.

10. LED nach Anspruch 1, **dadurch gekennzeichnet, dass**
zwischen der zweiten Barriereschicht (7) und der ersten Kontaktschicht (9) eine Stromverteilerschicht (8) des zweiten Leitfähigkeitstyps zur Verteilung eines über einen leitenden Querschnitt (20) zwischen der ersten Kontaktschicht (9) und dem Substratkontakt (1) fließenden Stromes vorhanden ist, die für die emittierte Strahlung durchlässig ist und die Stromverteilerschicht (8) aus einem transparenten, leitfähigen Material besteht.

11. LED nach Anspruch 1, **dadurch gekennzeichnet, dass**
der Substratkontakt (1) und die Oberflächenkontakte (10) als Bondflächen (10.2) ausgeführt sind, indem diese mindestens teilweise von einer Bondschicht (10.2) überdeckt sind.

12. LED nach Anspruch 7 und 8, **dadurch gekennzeichnet, dass**
der Substratkontakt (1) mit der Pufferschicht (3) durch mindestens einen metallischen Leiter (22) verbunden ist, der durch mindestens einen in dem elektrisch isolierenden Substrat (2.1) vorhandenen Kanal (23) verlaufend angeordnet ist.

13. LED nach Anspruch 11, **dadurch gekennzeichnet, dass**
der Substratkontakt (1) an seiner Unterseite mit einer die emittierte Strahlung reflektierende Schicht beschichtet ist und zusammen mit dem mindestens einen metallischen Leiter (22) im isolierenden Substrat (2.1) und der Pufferschicht (3) einen omni-direktionalen Reflektor darstellt.

14. Verfahren zur Herstellung einer LED nach Anspruch 1, **dadurch gekennzeichnet, dass**
die oberflächenimplantierten Bereiche (11) und die ersten tiefenimplantierten Bereiche (12.1), durch Bestrahlung der Folge von Schichten mit elektrischen Ladungsträgern verschiedener kinetischer Energien und Anzahlen von elektrischen Ladungsträgern je Querschnittsfläche eines für die Bestrahlung verwendeten Strahlenbündels, elektrisch und optisch isolierend gemacht werden, wobei die oberflächenimplantierten Bereiche mit, im Vergleich zu den tiefenimplantierten Bereichen (12), geringeren kinetischen Energien und höheren Anzahlen von elektrischen Ladungsträgern je Querschnittsfläche des Strahlenbündels erzeugt sind und die tiefenimplantierten Bereiche (12.1) von der ersten Kontaktschicht (9) in senkrechter Richtung erstreckt ausgebildet sind.

15. LED-Array mit einer Mehrzahl von LEDs nach Anspruch 1, **dadurch gekennzeichnet, dass** eine Anzahl von emittierenden Oberflächen (13) auf einem gemeinsamen Substrat (2) in einem Array (15) angeordnet sind.

16. LED-Array nach Anspruch 15, **dadurch gekennzeichnet, dass** neben den ersten tiefenimplantierten Bereichen (12.1) zweite tiefenimplantierte Bereiche (12.2) vorhanden sind durch alle Schichten bis zu dem elektrisch isolierenden Substrat (2.1) reichen und über dem isolierenden Substrat (2.1) eine zweite Kontaktschicht (14) eines ersten Leitfähigkeitstyps vorhanden ist, zwischen zweiter Barriereschicht (7) und erster Kontaktschicht (9) eine Stromverteilerschicht (8) des zweiten Leitfähigkeitstyps vorhanden ist und ferner die Oberflächenkontakte (10) als voneinander elektrisch isolierte erste Streifen (10.1) ausgebildet sind, durch die je eine Anzahl von emittierenden Oberflächen (13) in einer ersten Richtung (17) des Arrays (15) kontaktiert werden und die zweite Kontaktschicht (14) als eine Anzahl voneinander elektrisch isolierter zweiter Streifen (14.1) ausgebildet ist, die in einer senkrecht zur ersten Richtung (17) des Arrays (15) weisenden zweiten Richtung (18) des Arrays (15) verlaufen, so dass durch die in der ersten Richtung (17) verlaufenden ersten Streifen (10.1) und die in der zweiten Richtung (18) verlaufendenden zweiten Streifen (14.1) in der Draufsicht ein Netz mit Kreuzungspunkten (19) der ersten und zweiten Streifen (10.1 und 14.1) gebildet ist und jede emittierende Oberfläche (13) über je einem der Kreuzungspunkte (19) angeordnet ist.

17. LED-Array nach Anspruch 4716, **dadurch gekennzeichnet, dass** die ersten Streifen (10.1) und die zweiten Streifen (14.1) durch eine Steuerung (16) selektiv kontaktierbar ausgeführt sind, so dass durch die Steuerung (16) für jede einzelne emittierende Oberfläche (13), unabhängig von anderen emittierenden Oberflächen (13), ein gerichteter Stromfluss zwischen einem ersten Streifen (10.1) und einem zweiten Streifen (14.1) senkrecht zu einem Kreuzungspunkt (19) steuerbar ist.

18. Verwendung einer LED nach einem der Ansprüche 1-13 oder eines LED-Arrays nach einem der Ansprüche 15 bis 17 zur Einspiegelung von optisch wahrnehmbaren graphischen Zeichen in den Strahlengang einer optischen Anordnung.

## Claims

1. Surface emitting semiconductor light-emitting diode, LED, comprising a sequence arranged one above another of:
- a layer of a substrate contact (1) of a first conductivity type,
- a common substrate (2),
- a first barrier layer (5) of the first conductivity type,
- a light-emitting active layer (6),
- a second barrier layer (7) of a second conductivity type, a first contact layer (9) of the second conductivity type, and surface-implanted regions (11) in the first contact layer (9) which are electrically insulated from one another by irradiation with electrical charge carriers, and a number of electrically conductive surface contacts (10) for contacting the first contact layer (9), **characterized**
- **in that** the substrate (2) consists of a semiconductor substrate and the substrate (2) has a first conductivity type or the substrate (2) is an electrically insulating substrate (2.1) or the substrate (2) consists of a metal or a composite material,
- **in that** a reflector layer (4) of the first conductivity type is present between the substrate (2) and the first barrier layer (5),
- **in that** the first contact layer (9) has at least one emitting surface (13) via which radiation emitted by the active layer (6) emerges from the LED, and the emitting surfaces (13) are surrounded by surface-implanted regions (11) in the first contact layer (9) which are irradiated with electrical charge carriers and which are embodied as electrically insulating and optically isolating, and
- **in that** the regions of the layers which are situated below the emitting surface (13), proceeding from the first contact layer (9) and extending as far as at least through the active layer (6) and into the reflector layer (4), are electrically insulated and optically isolated from regions of the layers which are not situated below the emitting surface (13) by means of first deep-implanted regions (12.1) irradiated with electrical charge carriers, wherein the deep-implanted regions (12.1) are embodied in a manner extended from the first contact layer (9) in a perpendicular direction, and
- **in that** the deep-implanted regions (12.1) have a smaller horizontal extent than the surface-implanted regions (11), and in that the deep-implanted regions have a ring-shaped cross section that remains constant over the perpendicular extent of the deep-implanted regions, and in that the surface-implanted regions are extended across the whole area over the entire surface of the LED with the exception of the emitting surfaces (13).

2. LED according to Claim 1, **characterized in that** a plurality of emitting surfaces (13) are present, and the deep-implanted regions (12.1, 12.2) of the individual emitting surfaces (13) are spaced apart from one another.

3. LED according to Claim 1, **characterized in that** the first conductivity type and the second conductivity type are selected from a group comprising the conductivity types of p-doped and n-doped semiconductors, and the first conductivity type and the second conductivity type differ from one another.

4. LED according to Claim 2, **characterized in that** the first barrier layer (5) and the second barrier layer (7) each have a bandgap that is greater than the bandgap of the active layer (6).

5. LED according to Claim 3, **characterized in that** the materials of the first and second barrier layers (5, 7), the first contact layer (9) and the active layer (6) are selected from a group comprising (AlₓGa₁₋ₓ)_{1-z}In_{z}P and AlₓGa₁₋ₓAs, wherein 0 ≤ x ≤ 1 and 0 ≤ z ≤ 0.6, or the materials of the first and second barrier layers (5, 7), the first contact layer (9) and the active layer (6) consist of AlₓGa_{y}In_{z}N, where x + y + z = 1, 0 ≤ x ≤ 1, 0 ≤ y ≤ 1, 0 ≤ z ≤ 0.5, or In_{y}Ga_{1-y}N, where 0 ≤ y ≤ 0.5, is selected as material of the first and second barrier layers (5, 7), the first contact layer (9) and the active layer (6), and the substrate (2) is selected from a group comprising germanium, silicon and metal alloys.

6. LED according to Claim 1, **characterized in that** the active layer (6) is embodied as a quantum well or multi quantum well or consists of an undoped or a p-doped or an n-doped material and is arranged no deeper than 4 µm below the emitting surfaces (13).

7. LED according to Claim 1, **characterized in that** the substrate (2) consists of a doped material, selected from a group comprising Si, GaAs, Ge and metal alloys.

8. LED according to Claim 1, **characterized in that** the substrate (2) is embodied as an electrically insulating substrate (2.1), and the electrically insulating substrate (2.1) consists of a material selected from a group comprising sapphire, Si-AlN, MgAl₂O₄ spinel, metal oxides or composites.

9. LED according to Claim 1, **characterized in that** a buffer layer (3) of the first conductivity type is present between substrate (2) and first barrier layer (5) in order to compensate for mutually different crystalline structures of the layers.

10. LED according to Claim 1, **characterized in that** a current spreading layer (8) of the second conductivity type is present between the second barrier layer (7) and the first contact layer (9) in order to spread a current flowing between the first contact layer (9) and the substrate contact (1) over a conducting cross section (20), the current spreading layer (8) being transmissive to the emitted radiation and consisting of a transparent, conductive material.

11. LED according to Claim 1, **characterized in that** the substrate contact (1) and the surface contacts (10) are embodied as bonding surfaces (10.2) by virtue of their being at least partly covered by a bonding layer (10.2).

12. LED according to Claims 7 and 8, **characterized in that**
the substrate contact (1) is connected to the buffer layer (3) by at least one metallic conductor (22) which is arranged so as to run through at least one channel (23) present in the electrically insulating substrate (2.1).

13. LED according to Claim 11, **characterized in that** the substrate contact (1) is coated on its underside with a layer that reflects the emitted radiation, and, together with the at least one metallic conductor (22) in the insulating substrate (2.1) and the buffer layer (3), constitutes an omnidirectional reflector.

14. Method for producing an LED according to Claim 1, **characterized in that**
the surface-implanted regions (11) and the first deep-implanted regions (12.1) are made electrically insulating and optically isolating by irradiation of the sequence of layers with electrical charge carriers having different kinetic energies and numbers of electrical charge carriers per cross-sectional area of a beam used for the irradiation, wherein the surface-implanted regions are produced with lower kinetic energies and higher numbers of electrical charge carriers per cross-sectional area of the beam in comparison with the deep-implanted regions (12), and the deep-implanted regions (12.1) are embodied in a manner extended from the first contact layer (9) in a perpendicular direction.

15. LED array comprising a plurality of LEDs according to Claim 1, **characterized in that**
a number of emitting surfaces (13) are arranged in an array (15) on a common substrate (2).

16. LED array according to Claim 15, **characterized in that**
besides the first deep-implanted regions (12.1), second deep-implanted regions (12.2) are present, the latter extending through all layers as far as the electrically insulating substrate (2.1), and a second contact layer (14) of a first conductivity type is present over the insulating substrate (2.1), a current spreading layer (8) of the second conductivity type is present between second barrier layer (7) and first contact layer (9), and furthermore the surface contacts (10) are embodied as first strips (10.1) which are electrically insulated from one another and which respectively contact a number of emitting surfaces (13) in a first direction (17) of the array (15), and the second contact layer (14) is embodied as a number of second strips (14.1) which are electrically insulated from one another and which extend in a second direction (18) of the array (15), said second direction being oriented perpendicular to the first direction (17) of the array (15), such that as a result of the first strips (10.1) extending in the first direction (17) and the second strips (14.1) extending in the second direction (18), in plan view, a network with crossover points (19) of the first and second strips (10.1 and 14.1) is formed and each emitting surface (13) is arranged over a respective one of the crossover points (19).

17. LED array according to Claim 16, **characterized in that**
the first strips (10.1) and the second strips (14.1) are embodied such that they are selectively contactable by a controller (16), such that a directional current flow between a first strip (10.1) and a second strip (14.1) perpendicular to a crossover point (19) is controllable by the controller (16) for each individual emitting surface (13), independently of other emitting surfaces (13).

18. Use of an LED according to any of Claims 1-13 or of an LED array according to any of Claims 15 to 17 for reflecting optically perceptible graphical characters into the beam path of an optical arrangement.

## Revendications

1. Diode électroluminescente, LED, à émission par la surface, comprenant une séquence des éléments ci-après disposés les uns au-dessus des autres :
- une couche d'un contact de substrat (1) d'un premier type de conductivité,
- un substrat (2) commun,
- une première couche barrière (5) du premier type de conductivité,
- une couche active (6) émettrice de lumière,
- une deuxième couche barrière (7) d'un deuxième type de conductivité, une première couche de contact (9) du deuxième type de conductivité et des zones implantées en surface (11) dans la première couche de contact (9) isolées électriquement les unes par rapport aux autres par irradiation avec des porteurs de charges électriques, ainsi qu'un certain nombre de contacts de surface (10) électriquement conducteurs destinés à la mise en contact de la première couche de contact (9), **caractérisée en ce**
- **que** le substrat (2) se compose d'un substrat en semiconducteur et le substrat (2) possède un premier type de conductivité ou le substrat (2) est un substrat électriquement isolant (2.1) ou le substrat (2) se compose d'un métal ou d'un matériau composite,
- **qu'**entre le substrat (2) et la première couche barrière (5) se trouve une couche de réflexion (4) du premier type de conductivité,
- **que** la première couche de contact (9) possède au moins une surface émettrice (13), par le biais de laquelle le rayonnement émis par la couche active (6) sort de la LED et les surfaces émettrices (13) sont entourées par des zones implantées en surface (11) dans la première couche de contact (9) irradiées avec des porteurs de charges électriques, lesquelles sont configurées isolantes électriquement et optiquement et
- **que** les zones des couches qui se trouvent sous la surface émettrice (13), à partir de la première couche de contact (9) jusqu'au moins à travers la couche active (6) et en s'étendant jusque dans la couche de réflexion (4), sont isolées électriquement et optiquement, par des premières zones implantées en profondeur (12.1) irradiées par des porteurs de charges électriques, des zones des couches qui se trouvant sous la surface émettrice (13), les zones implantées en profondeur (12.1) étant configurées étendues dans la direction perpendiculaire depuis la première couche de contact (9) et
- **que** les zones implantées en profondeur (12.1) présentent une étendue horizontale plus petite que les zones implantées en surface (11) et en ce que les zones implantées en profondeur présentent une section transversale annulaire, constante sur l'étendue perpendiculaire de la zone implantée en profondeur, et en ce que les zones implantées en surface sont étendues de toute leur surface sur la totalité de la surface de la LED à l'exception des surfaces émettrices (13).

2. LED selon la revendication 1, **caractérisée en ce que** plusieurs surfaces émettrices (13) sont présentes et les zones implantées en profondeur (12.1, 12.2) des surfaces émettrices (13) individuelles sont espacées les unes des autres.

3. LED selon la revendication 1, **caractérisée en ce que** le premier type de conductivité et le deuxième type de conductivité sont choisis dans un groupe comprenant les types de conductivité de semiconducteur dopé p et dopé n et le premier type de conductivité et le deuxième type de conductivité sont différents l'un de l'autre.

4. LED selon la revendication 2, **caractérisée en ce que** la première couche barrière (5) et la deuxième couche barrière (7) présentent respectivement un écart énergétique qui est supérieur à l'écart énergétique de la couche active (6).

5. LED selon la revendication 3, **caractérisée en ce que** les matériaux de la première et de la deuxième couche barrière (5, 7) de la première couche de contact (9) ainsi que de la couche active (6) sont choisis dans un groupe comprenant l' (AlₓGa₁₋ₓ)_{1-z}In_{z}P et l'AlₓGa₁₋ₓAs, où 0 ≤ x ≤ 1 et 0 ≤ z ≤ 0,6, ou les matériaux de la première et de la deuxième couche barrière (5, 7) de la première couche de contact (9) ainsi que de la couche active (6) se composent d'AlₓGa_{y}In_{z}N, où x+y+z=1, 0 ≤ x ≤ 1, 0 ≤ y ≤ 1, 0 ≤ z ≤ 0,5, ou l'In_{y}Ga_{1-y}N est choisi comme matériau de la première et de la deuxième couche barrière (5, 7) de la première couche de contact (9) ainsi que de la couche active (6), où 0 ≤ y ≤ 0,5, et le substrat (2) est choisi dans un groupe comprenant le germanium, le silicium et des alliages métalliques.

6. LED selon la revendication 1, **caractérisée en ce que** la couche active (6) est réalisée sous la forme d'un puits quantique ou d'un multi-puits quantique, ou se compose d'un matériau non dopé ou dopé p ou dopé n et n'est pas disposée plus profondément que 4 µm sous les surfaces émettrices (13).

7. LED selon la revendication 1, **caractérisée en ce que** le substrat (2) se compose d'un matériau dopé, choisi dans un groupe comprenant le Si, le GaAs, le Ge et des alliages métalliques.

8. LED selon la revendication 1, **caractérisée en ce que** le substrat (2) est réalisé sous la forme d'un substrat électriquement isolant (2.1) et le substrat électriquement isolant (2.1) se compose d'un matériau choisi dans un groupe comprenant le saphir, la si-AIN, le MgAl₂O₄, des oxydes métalliques ou des composites.

9. LED selon la revendication 1, **caractérisée en ce qu'**une couche tampon (3) du premier type de conductivité est présente entre le substrat (2) et la première couche barrière (5) en vue de compenser les structures cristallines différentes les unes des autres des couches.

10. LED selon la revendication 1, **caractérisée en ce qu'**une couche de distribution de courant (8) du deuxième type de conductivité est présente entre la deuxième couche barrière (7) et la première couche de contact (9) en vue de distribuer un courant qui circule par le biais d'une section transversale conductrice (20) entre la première couche de contact (9) et le contact de substrat (1), laquelle est transparente pour le rayonnement émis et la couche de distribution de courant (8) se compose d'un matériau conducteur transparent.

11. LED selon la revendication 1, **caractérisée en ce que** le contact de substrat (1) et les contacts de surface (10) sont réalisés sous la forme de surfaces métallisées (10.2), **en ce que** ceux-ci sont recouverts au moins partiellement par une couche de métallisation (10.2).

12. LED selon la revendication 7 et 8, **caractérisée en ce que** le contact de substrat (1) est relié à la couche tampon (3) par au moins un conducteur métallique (22), lequel est disposé en suivant un tracé à travers au moins un canal (23) présent dans le substrat électriquement isolant (2.1).

13. LED selon la revendication 11, **caractérisée en ce que** le contact de substrat (1) est enduit sur son côté inférieur d'une couche réfléchissant le rayonnement émis et, conjointement avec l'au moins un conducteur métallique (22) dans le substrat isolant (2.1) et la couche tampon (3), représente un réflecteur omnidirectionnel.

14. Procédé de fabrication d'une LED selon la revendication 1, **caractérisé en ce que**
les zones implantées en surface (11) et les premières zones implantées en profondeur (12.1), sont rendues électriquement et optiquement isolantes par irradiation de la séquence de couches avec des porteurs de charges électriques ayant des énergies cinétiques différentes et des nombres différents de porteurs de charges électriques par surface de section transversale d'un faisceau de rayons utilisé pour l'irradiation, les zones implantées en surface étant générées avec des énergies cinétiques plus faibles et des nombres plus élevés de porteurs de charges électriques par surface de section transversale du faisceau de rayons par rapport aux zones implantées en profondeur (12) et les zones implantées en profondeur (12.1) sont configurées étendues dans la direction perpendiculaire depuis la première couche de contact (9).

15. Matrice de LED comprenant une pluralité de LED selon la revendication 1, **caractérisée en ce qu'**un certain nombre de surfaces émettrices (13) sont disposées sur un substrat (2) commun dans une matrice (15).

16. Matrice de LED selon la revendication 15, **caractérisée en ce qu'**en plus des premières zones implantées en profondeur (12.1), des deuxièmes zones implantées en profondeur (12.2) sont présentes, s'étendent à travers toutes les couches jusqu'au substrat électriquement isolant (2.1) et une deuxième couche de contact (14) d'un premier type de conductivité se trouve au-dessus du substrat électriquement isolant (2.1), une couche de distribution de courant (8) du deuxième type de conductivité est présente entre la deuxième couche barrière (7) et la première couche de contact (9) et les contacts de surface (10) sont en outre réalisés sous la forme de premières bandes (10.1) isolées électriquement les unes des autres, par lesquelles un certain nombre de surfaces émettrices (13) sont respectivement mises en contact dans une première direction (17) de la matrice (15) et la deuxième couche de contact (14) est réalisée sous la forme d'un certain nombre de deuxièmes bandes (14.1) isolées électriquement les unes des autres, lesquelles suivent un tracé dans une deuxième direction (18) de la matrice (15) dirigée perpendiculairement à la première direction (17) de la matrice (15), de sorte qu'un réseau comportant des points d'intersection (19) des premières et deuxièmes bandes (10.1 et 14.1) est formé, vue de dessus, par les premières bandes (10.1) qui suivent un tracé dans la première direction (17) et les deuxièmes bandes (14.1) qui suivent un tracé dans la deuxième direction (18), et chaque surface émettrice (13) est disposée au-dessus de l'un respectif des points d'intersection (19).

17. Matrice de LED selon la revendication 16, **caractérisée en ce que** les premières bandes (10.1) et les deuxièmes bandes (14.1) sont réalisées de manière à pouvoir être mises en contact sélectivement par une commande (16), de sorte qu'un flux de courant entre une première bande (10.1) et une deuxième bande (14.1) dirigé perpendiculairement à un point d'intersection (19) peut être commandé par la commande pour chaque surface émettrice (13) individuelle, indépendamment des autres surfaces émettrices (13).

18. Utilisation d'une LED selon l'une des revendications 1 à 13 ou d'une matrice de LED selon l'une des revendications 15 à 17 pour l'introduction par réflexion de symboles graphiques perceptibles optiquement dans le trajet de rayon d'un arrangement optique.
